# EUROPÄISCHE PATENTANMELDUNG

(11) **EP 4 415 038 A1**
(43) Veröffentlichungstag der Anmeldung: **14.08.2024**
(21) Anmeldenummer: 23155583.0
(22) Anmeldetag: 08.02.2023
(51) Int. Cl.: H01L 23/373, H05K 1/02, H01L 29/16

(54) **SCHALTUNGSANORDNUNG**

(71) Anmelder: Siemens Aktiengesellschaft, 80333 München (DE)
(72) Erfinder: Hensler, Alexander, 91466 Gerhardshofen (DE); Pfefferlein, Stefan, 90562 Heroldsberg (DE); Strogies, Jörg, 14163 Berlin (DE); Woiton, Michael, 90425 Nürnberg (DE); Bigl, Thomas, 91074 Herzogenaurach (DE); Heimann, Matthias, 14469 Potsdam (DE); Müller, Bernd, 16259 Falkenberg (DE); Wilke, Klaus, 12527 Berlin (DE)
(74) Vertreter: Siemens Patent Attorneys

(57) **Zusammenfassung**

Es wird eine Schaltungsanordnung mit einem Halbleiterbauelement angegeben, die wenigstens ein Wärmeleitelement mit einer spezifischen Wärmeleitfähigkeit von wenigstens 20 W/mK aufweist, das das Halbleiterbauelement lateral zu wenigstens 50% umschließt und in mechanischem Kontakt mit den Seitenflächen des Halbleiterbauelements steht und wenigstens die halbe Höhe des Halbleiterbauelements aufweist.

## Beschreibung

Die Erfindung betrifft eine Schaltungsanordnung mit einem Schaltungsträger, der auf einer Seite eine elektrisch leitfähige Schicht aufweist und einem auf der elektrisch leitfähigen Schicht angeordneten Halbleiterbauelement.

In der Leistungselektronik ist die Entwärmung von Halbleiterbauelementen ein zentrales Problem. Dabei ist sowohl das transiente Verhalten als auch das stationäre Verhalten wichtig und sollte möglichst in Richtung geringer thermischer Widerstände gestaltet sein.

Die initiale Wärmespreizung und Ableitung findet dabei üblicherweise durch eine metallische Schicht statt, auf der das Halbleiterbauelement angeordnet ist. Die metallische Schicht ist wiederum direkt oder indirekt mit einem Kühlkörper verbunden. Wird die metallische Schicht für eine verstärkte Wärmespreizung und Ableitung verdickt, erhöht das nachteilig die Bauhöhe und den thermischen Serienwiderstand zum Kühlkörper. Wird die metallische Schicht dagegen dünner gemacht, verringert das die Effektivität als Wärmespreizer und Wärmekapazität für transienten Wärmeeintrag.

Es ist Aufgabe der vorliegenden Erfindung, eine Schaltungsanordnung anzugeben, die die eingangs genannten Nachteile vermindert.

Diese Aufgabe wird durch eine Schaltungsanordnung mit den in Anspruch 1 angegebenen Merkmalen gelöst.

Die erfindungsgemäße Schaltungsanordnung umfasst einen Schaltungsträger, der auf einer Seite eine elektrisch leitfähige Schicht aufweist, ein auf der elektrisch leitfähigen Schicht angeordnetes Halbleiterbauelement und ein Wärmeleitelement mit einer spezifischen Wärmeleitfähigkeit von wenigstens 20 W/mK, das das Halbleiterbauelement lateral zu wenigstens 50% umschließt und in mechanischem Kontakt mit den Seitenflächen des Halbleiterbauelements steht und wenigstens die halbe Höhe des Halbleiterbauelements aufweist.

Die Erfindung stellt also mit anderen Worten eine chipnahe Wärmekapazität zur Verbesserung des transienten Entwärmungsverhaltens zur Verfügung. Dabei wird vorteilhaft ein steigender Serienwiderstand in Richtung Kühler vermieden. Es wurde für die Erfindung erkannt, dass die Seitenflächen der Halbleiterbauelemente bei aktuellen Aufbauten nicht oder nicht optimal zur Wärmeableitung genutzt werden. Insbesondere SiC-Chips sind lateral tendenziell eher klein, aber dafür vergleichsweise dick, so dass hier die bisher zur Wärmeabfuhr wenig genutzten Umfangsflächen an Bedeutung gewinnen. Es ist hiermit ein Flächenzugewinn von etwa 20 % möglich.

Lateral bezeichnet dabei die Seiten des Halbleiterbauelements. Das Halbleiterbauelement ist typischerweise mit einer Unterseite auf dem Schaltungsträger angeordnet und weist auf der Unterseite und der gegenüber liegenden Oberseite elektrische Kontaktflächen auf. Die vier verbleibenden, im Allgemeinen vergleichsweise kleinen Seitenflächen sind die lateralen Flächen oder Seitenflächen.

Vorteilhafte Ausgestaltungen der erfindungsgemäßen Schaltungsanordnung gehen aus den abhängigen Ansprüchen hervor. Dabei kann die Ausführungsform der unabhängigen Ansprüche mit den Merkmalen eines der Unteransprüche oder vorzugsweise auch mit denen aus mehreren Unteransprüchen kombiniert werden. Demgemäß können noch zusätzlich folgende Merkmale vorgesehen werden:
Das Wärmeleitelement kann eine spezifische Wärmeleitfähigkeit von wenigstens 40 W/mK, insbesondere wenigstens 200 W/mK und in einer besonderen Ausgestaltung wenigstens 350 W/mK aufweisen. Mit einer sehr hohen Wärmeleitfähigkeit trägt das Wärmeleitelement in besonderer Weise zu einer schnellen Entwärmung gerade bei Wärmespitzen bei. Die übliche Entwärmung durch die Unterseite das Halbleiterbauelements wird dadurch besonders gut unterstützt durch eine Wärmeableitung zur Seite.

Das Wärmeleitelement kann das Halbleiterbauelement zu wenigstens 80%, insbesondere vollständig lateral umschließen. Dabei umfasst das Umschließen auch insbesondere den mechanischen Kontakt des Wärmeleitelements mit den Seitenflächen des Halbleiterelements. Je mehr das Wärmeleitelement das Halbleiterbauelement umschließt, desto mehr Kontaktfläche besteht zwischen den Seitenflächen des Halbleiterbauelements und dem Wärmeleitelement. Dadurch wird die Wärmeleitung in das Wärmeleitelement verstärkt oder anders betrachtet der thermische Widerstand verringert und somit die Entwärmung des Halbleiterbauelements verbessert.

Das Wärmeleitelement kann eine Höhe von wenigstens 90% der Höhe des Halbleiterbauelements aufweisen, insbesondere seine volle Höhe. Dabei wird davon ausgegangen, dass das Wärmeleitelement auf gleicher Höhe mit dem Halbleiterbauelement angeordnet ist, sodass 90% oder die gesamte Höhe der Seitenfläche des Halbleiterbauelements mit dem Wärmeleitelement in direktem mechanischem Kontakt steht. Beträgt die Höhe des Wärmeleitelements wenigstens die gesamte Höhe des Halbleiterbauelements, bedeutet das mit anderen Worten, dass die gesamte Seitenfläche des Halbleiterbauelements - soweit es vom Wärmeleitelement umlaufen wird - bedeckt ist vom Wärmeleitelement. Durch eine möglichst großflächige Bedeckung der Seitenflächen wird die Wärmeleitung zum Wärmeleitelement verbessert oder mit anderen Worten der thermische Widerstand verringert. Dadurch wird die Entwärmung des Halbleiterbauelements verbessert.

Das Wärmeleitelement kann in einer weiteren Ausgestaltung der Erfindung auch höher als das Halbleiterbauelement sein. In diesem Fall ist es besonders vorteilhaft, wenn es einen Teil der vom Schaltungsträger abgewandten Oberseite des Halbleiterbauelements bedeckt. Mit anderen Worten liegt das Wärmeleitelement dann nicht nur an den Seitenflächen des Halbleiterbauelements an, sondern auch an einem Teil der Oberseite. Dadurch wird die Berührungsfläche zwischen dem Wärmeleitelement und dem Halbleiterbauelements vergrößert und der thermische Kontakt zwischen Wärmeleitelement und Halbleiterbauelement weiter verbessert, also die Wärmeableitung aus dem Halbleiterbauelement noch verstärkt. Zweckmäßig sind dabei solche Teile der Oberseite des Halbleiterbauelements nicht oder nicht vollständig vom Wärmeleitelement bedeckt, an denen sich elektrische Kontaktflächen befinden.

Dabei kann es vorteilhaft sein, wenn das Wärmeleitelement elektrisch isolierend ist, also aus einem elektrisch isolierenden Material besteht. Unter elektrisch isolierend wird eine spezifische elektrische Leitfähigkeit von höchstens 10⁻⁶ S/m verstanden. Hierdurch wird vermieden, dass elektrische Fehlschlüsse bewirkt werden, wenn das Wärmeleitelement mit den Kontaktflächen des Halbleiterbauelements oder den Leiterbahnen in Berührung kommt. Vor allem ist es dann von Vorteil, wenn das Wärmeleitelement auch Teile der Oberseite des Halbleiterbauelements bedeckt, da dann eine größere Nähe zu den Kontaktflächen und Leiterbahnen gegeben sein kann.

In einer alternativen Weiterbildung der Erfindung ist das Wärmeleitelement elektrisch leitfähig. Mit elektrisch leitfähig ist hierbei eine spezifische elektrische Leitfähigkeit von wenigstens 10⁵ S/m gemeint, die also geeignet ist, einen merklichen Beitrag zur Leitfähigkeit von Kontaktflächen und Leiterbahnen zu liefern. Besonders vorteilhaft ist es in diesem Fall, wenn das Wärmeleitelement bündig mit den Oberseiten von Kontaktflächen des Halbleiterbauelements abschließt und dabei in Berührung mit wenigstens einer Kontaktfläche und einer der Kontaktfläche zugeordneten elektrischen Leiterbahn steht. Hierdurch wird ein zusätzlicher Strompfad bereitgestellt, also der elektrische Widerstand und damit Verluste im Bereich des Wärmeleitelements verringert. Mit anderen Worten wird der Leiterbahnquerschnitt im Bereich des Wärmeleitelements verringert. Daneben wird auch eine gute thermische Anbindung geschaffen, bei der eine verbesserte Wärmeableitung auch über die Leiterbahnen erreicht wird. Das Wärmeleitelement kann hierbei vorteilhaft Unterteilungen aufweisen, um einen Querschluss zwischen verschiedenen Leiterbahnen zu vermeiden. Auch wenn das Wärmeleitelement solche Unterteilungen aufweist, wird es hier noch als ein Wärmeleitelement behandelt.

Die Schaltungsanordnung kann ein mechanisch mit dem Wärmeleitelement verbundenes Wärmespeicherelement aufweisen. Das Wärmespeicherelement ist dabei neben dem Halbleiterbauelement auf dem Schaltungsträger angeordnet und weist eine Wärmekapazität von wenigstens 0,01 J/K, insbesondere wenigstens 0,05 J/K und eine spezifische Wärmeleitfähigkeit von wenigstens 20 W/mK auf. Weiterhin ist das Wärmeleitelement mechanisch mit einer Seitenfläche des Wärmespeicherelements verbunden. Insbesondere bedeckt das Wärmeleitelement wenigstens eine der Seitenflächen des Wärmespeicherelements. Unter Seitenflächen des Wärmespeicherelements werden hierbei analog zum Halbleiterbauelement die im Wesentlichen senkrecht zum Schaltungsträger stehenden Flächen verstanden, während die zu Schaltungsträger weisende Fläche als Unterseite und die gegenüberliegende Seite als Oberseite bezeichnet wird.

Vorteilhaft schaffen das Wärmespeicherelement und das Wärmeleitelement zusammen eine Möglichkeit, transient auftretende hohe Abwärmemengen schnell vom Halbleiterbauelement abzuführen und zwischenzuspeichern, bis eine Abgabe der Wärme über den Schaltungsträger und Kühlkörper erfolgt. Das wird vorteilhaft dadurch erreicht, dass die laterale Ausdehnung des Wärmeleitelements, also der Abstand zwischen dem Halbleiterbauelement und dem Wärmespeicherelement, zweckmäßig deutlich geringer ist als die Dicke des Schaltungsträgers, also der Abstand zum Wärmespeicherelement und damit der thermische Widerstand gering. Die Wärmekapazität des Wärmespeicherelements und seine spezifische Wärmeleitfähigkeit, die insbesondere wenigstens 100 W/mK und in einer besonderen Ausgestaltung wenigstens 350 W/mK betragen kann, sorgen für eine besonders schnelle Abführung einer merklichen Menge an Abwärme in vergleichsweise kurzer Zeit.

Dabei ist es vorteilhaft, wenn das Wärmespeicherelement elektrisch nichtleitend ist, da es dann geometrisch freier gestaltet werden kann, ohne dabei auf die Gefahr von elektrischen Kurzschlüssen achten zu müssen.

Vorteilhaft ist es, wenn das Wärmespeicherelement eine Diamantfolie umfasst. Das Diamantmaterial weist eine spezifische Wärmeleitfähigkeit von bis zu 2000 W/mK auf und kann somit Abwärme äußerst schnell vom Halbleiterbauelement abführen, was zu einer deutlichen thermischen Entlastung des Halbleiterbauelements bei Abwärmespitzen führt.

In einer Ausgestaltung der Erfindung umfasst die Schaltungsanordnung einen auf einer Oberseite des Halbleiterbauelements angeordneten zweiten Schaltungsträger. Dadurch kann ein Aufbau bereitgestellt werden, in dem Bonddrähte entfallen und durch Leiterbahnen auf den Schaltungsträgern ersetzt sind. Das ist vorteilhaft für die Stabilität und Lebensdauer der Schaltungsanordnung. Zweckmäßig umfasst dann das Halbleiterbauelement auf seiner Oberseite wenigstens eine Kontaktfläche und der zweite Schaltungsträger auf seiner dem Halbleiterbauelement zugewandten Seite wenigstens eine Leiterbahn zur Kontaktierung der Kontaktfläche.

Im Folgenden wird die Erfindung anhand der in den Figuren dargestellten Ausführungsbeispiele näher beschrieben und erläutert. Es zeigen:
- Figur 1: eine schematische Schnittdarstellung eines ersten Ausführungsbeispiels einer Schaltungsanordnung,
- Figur 2: eine schematische Schnittdarstellung eines zweiten Ausführungsbeispiels einer Schaltungsanordnung,
- Figur 3: eine schematische Schnittdarstellung eines dritten Ausführungsbeispiels einer Schaltungsanordnung,

Einander entsprechende Teile sind in den Figuren mit denselben Bezugszeichen versehen.

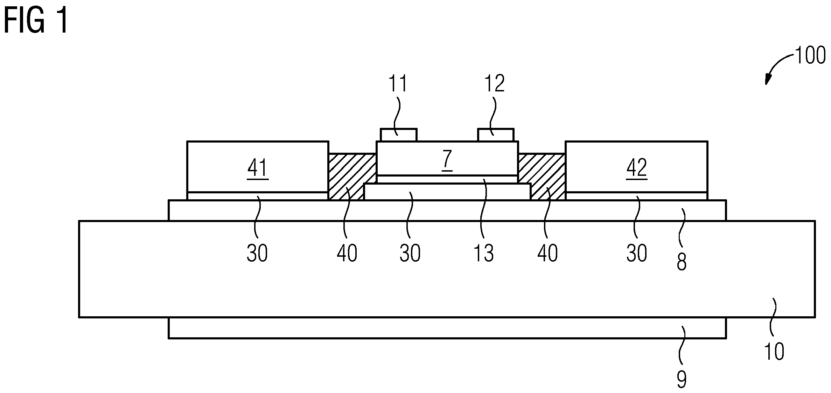

Figur 1 zeigt ein Leistungsmodul 100 mit einem Halbleiterbauelement 7. Das Halbleiterbauelement 7 ist bei diesem Ausführungsbeispiel ein SiC-Transistor mit einem Steueranschluss-Kontaktpad 11, einem ersten Lastanschluss-Kontaktpad 12 und einem zweiten Lastanschluss-Kontaktpad 13. Beispielsweise ist der Transistor ein Bipolartransistor oder ein Bipolartransistor mit isolierter Gate-Elektrode (engl. Insulated-Gate Bipolar Transistor, abgekürzt IGBT), dessen erster Lastanschluss ein Emitter-Anschluss ist und dessen zweiter Lastanschluss ein Kollektor-Anschluss ist. Alternativ ist der Transistor beispielsweise ein Feldeffekttransistor, insbesondere ein Metall-Oxid-Halbleiter-Feldeffekttransistor (engl. Metal-Oxide-Semiconductor Field-Effect Transistor, abgekürzt MOSFET), dessen erster Lastanschluss ein Source-Anschluss ist und dessen zweiter Lastanschluss ein Drain-Anschluss ist. Bei anderen Ausführungsbeispielen kann das Halbleiterbauelement 7 statt eines Transistors beispielsweise ein Thyristor oder eine Diode sein. Im Fall, dass das Halbleiterbauelement 7 eine Diode ist, entfallen jedoch der Steueranschluss und die mit ihm verbundenen Komponenten des Leistungsmoduls 100.

Das Leistungsmodul 100 umfasst ein Leistungssubstrat mit einem insbesondere keramischen Kern 10. Das Leistungssubstrat weist eine erste elektrisch leitfähige Schicht 8, eine zweite elektrisch leitfähige Schicht 9 und eine zwischen den beiden elektrisch leitfähigen Schichten 8, 9 angeordnete elektrisch isolierende Isolationsschicht 10 auf. Die erste elektrisch leitfähige Schicht 8 bildet eine dem Halbleiterbauelement 7 zugewandte Oberseite des zweiten Schaltungsträgers 5. Die zweite elektrisch leitfähige Schicht 9 bildet eine dem Halbleiterbauelement 7 abgewandte Unterseite des zweiten Schaltungsträgers 5. Die Isolationsschicht 10 ist beispielsweise eine Keramikschicht, die beispielsweise aus Aluminiumoxid, Aluminiumnitrid oder Siliziumnitrid gefertigt ist. Beispielsweise ist das Leistungssubstrat ein DCB-Substrat (DCB: Abkürzung für Direct Copper Bonded) oder ein AMB-Substrat (AMB: Abkürzung für Active Metal Brazing).

In diesem Ausführungsbeispiel sind das Steueranschluss-Kontaktpad 11 und das erste Lastanschluss-Kontaktpad 12 über nicht dargestellte Bonddrähte mit ebenfalls nicht gezeigten Leiterbahnen verbunden. Das zweite Lastanschluss-Kontaktpad 13 ist elektrisch mit der ersten elektrisch leitfähigen Schicht 8 des Leistungssubstrats verbunden. Die elektrischen Verbindungen zwischen diesen Komponenten werden durch ein Verbindungsmaterial 30, beispielsweise ein Lot- oder Sintermaterial, hergestellt, das zwei Komponenten elektrisch verbindet. Das Verbindungsmaterial kann von den verbundenen Komponenten abhängen, wird der Einfachheit halber aber für alle diese elektrischen Verbindungen in den Figuren mit demselben Bezugszeichen 30 bezeichnet.

Seitlich vom Halbleiterbauelement 7, also daneben sind ein erstes und zweites Wärmekapazitäts-Element 41, 42 angeordnet. Die Wärmekapazitäts-Elemente 41, 42 sind in diesem Beispiel metallisierte Diamantfolien. Sie sind über ein Verbindungsmaterial 30 mit der ersten elektrisch leitfähigen Schicht 8 verbunden, analog zum Halbleiterbauelement 7.

Die sich zwischen dem Halbleiterbauelement 7 und dem Wärmekapazitäts-Element 41, 42 ergebenden Zwischenräume sind durch ein oder mehrere Wärmespreiz-Elemente 40 zumindest teilweise aufgefüllt. Die Wärmespreiz-Elemente 40 bestehen aus einem hoch-wärmeleitfähigen Material, beispielsweise einem Diamantkomposit. Sie sind so aufgebracht, dass sie einen flächigen Materialschluss zu den Seitenflächen des Halbleiterbauelements 7 ausbilden. In Figur 1 ist die Höhe der Wärmespreiz-Elemente 40 etwas geringer als die des Halbleiterbauelements 7. In anderen Ausführungsformen können die Höhen auch übereinstimmen.

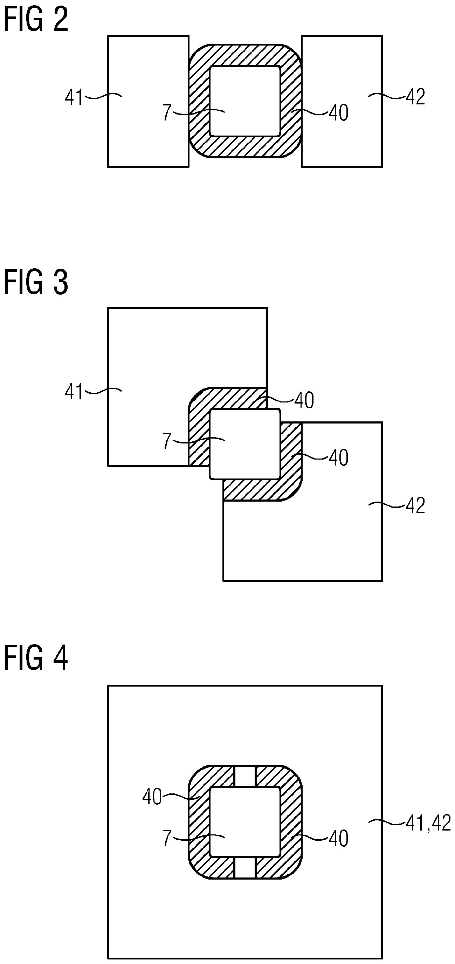

Die Figuren 2 bis 4 zeigen verschiedene Ausführungsbeispiele für die Anordnung des Halbleiterbauelements 7, der Wärmespreiz-Elemente 40 und der Wärmekapazitäts-Elemente 41, 42 in einer Draufsicht.

In dem Ausführungsbeispiel gemäß Figur 2 umschließt das Wärmespreiz-Element 40 das Halbleiterbauelement 7 ringartig und berührt somit alle Seitenflächen des Halbleiterbauelements 7. Das erste und zweite Wärmekapazitäts-Element 41, 42 sind jeweils rechteckförmig und schließen zu zwei Seiten an das Wärmespreiz-Element 40 an.

In dem Ausführungsbeispiel gemäß Figur 3 umschließt liegen zwei getrennte Wärmespreiz-Elemente 40 vor, die das Halbleiterbauelement 7 zu etwa drei Viertel ringartig umschließen und etwa ein Viertel der Seitenflächen in Bereichen um zwei der vier Ecken offenlassen. Das erste und zweite Wärmekapazitäts-Element 41, 42 wiederum umschließen die Wärmespreiz-Elemente 40.

In dem Ausführungsbeispiel gemäß Figur 4 umschließt das Wärmespreiz-Element 40 das Halbleiterbauelement 7 nahezu vollständig ringartig und weist lediglich zwei einander gegenüber liegende Unterbrechungen auf, sodass genau betrachtet zwei Wärmespreiz-Elemente 40 vorliegen. Die Seitenflächen des Halbleiterbauelements 7 werden daher nahezu vollständig umschlossen. In diesem Beispiel liegt lediglich ein Wärmekapazitäts-Element 41, 42 vor, das wiederum das Wärmespreiz-Element 40 ringartig umschließt.

Im laufenden Betrieb des Halbleiterbauelement 7 wird Abwärme durch Schaltvorgänge und durch Leitungsverluste erzeugt. Dabei kann die Abwärme transiente Spitzen aufweisen, bei denen in kurzer Zeit eine deutlich erhöhte Abwärmemenge anfällt. Diese erhöhte Abwärmemenge muss effizient abtransportiert werden. Um eine möglichst schnelle Spreizung der Abwärme zu erreichen, ist es vorteilhaft, wenn die erste elektrisch leitfähige Schicht 8 möglichst dick ist. Dadurch wird aber der Abstand und dadurch der thermische Widerstand zum Kühlkörper erhöht. Das Ziel einer idealen Wärmespreizung und gleichzeitig einer idealen Anbindung an den Kühlkörper sind also gleichzeitig nicht zu erreichen.

Durch die Wärmespreiz-Elemente 40, die eine sehr hohe thermische Leitfähigkeit von 1000 W/mK oder mehr im Falle von Diamantkompositen aufweisen, wird die Abwärme sehr effizient vom Halbleiterbauelement 7 abgeleitet und in die Wärmekapazitäts-Elemente 41, 42 abgegeben. Die Wärmeleitfähigkeit der Wärmekapazitäts-Elemente 41, 42 und der Wärmespreiz-Elemente 40 übertrifft dabei sogar die Wärmeleitfähigkeit des Kupfers deutlich. Vorteilhaft wird hier ausgenutzt, dass eine elektrische Leitfähigkeit nicht nötig und je nach Aufbau sogar hinderlich ist, sodass Materialien mit sehr hoher thermischer Leitfähigkeit ausgewählt werden können.

In der Folge wird die transient auftretende Abwärme dann durch die unterliegende erste elektrisch leitende Schicht 8 in Richtung Kühlkörper abgegeben. Dabei ist vorteilhaft, dass durch die Spreizung auf die Wärmekapazitäts-Elemente 41, 42 und Wärmespreiz-Elemente 40 die Abwärme über eine größere Fläche zum Kühlkörper transportiert werden kann.

Dadurch kann also gleichzeitig eine sehr effiziente Spreizung der Abwärme, insbesondere von transienten Abwärmespitzen erfolgen und der Serienwiderstand zum Kühlkörper gering gehalten werden, da eine Aufdickung beispielsweise der ersten elektrisch leitenden Schicht 8 zum Zweck der Wärmespreizung unterbleiben kann. Der Zielkonflikt zwischen Wärmespreizung und thermischer Leitung entfällt daher.

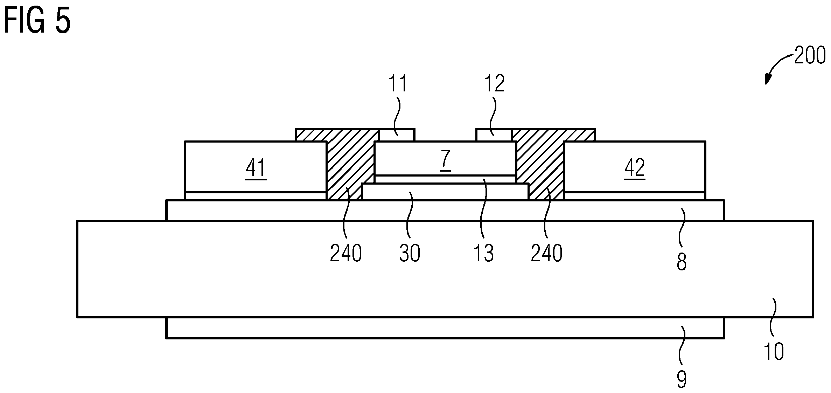

Figur 5 zeigt als weitere Ausführungsform für die Erfindung ein Leistungsmodul 200. Das Leistungsmodul 200 ist weitgehend aufgebaut wie das Leistungsmodul 100. Im Unterschied dazu sind aber die Wärmespreiz-Elemente 40 ersetzt durch Wärmespreiz-Elemente 240. Diese sind dicker als das Halbleiterbauelement 7 und die Wärmekapazitäts-Elemente 41, 42. Die Wärmespreiz-Elemente 240 überdecken einen Teil der Oberseite des Halbleiterbauelements 7 und auch der Wärmekapazitäts-Elemente 41, 42. In dieser Ausgestaltung ist es zweckmäßig, wenn das für die Wärmespreiz-Elemente 240 verwendete Material ausreichend elektrisch isolierend ist, um ungewollte elektrische Verbindungen zwischen den Kontaktpads 11, 12, 13 zu vermeiden. Durch die vollständige Anbindung der Seitenflächen des Halbleiterbauelements 7 und eines Teils der Oberseite, also der von der ersten elektrisch leitfähigen Schicht 8 abgewandten Seite, wird die effektive Fläche für den Abtransport von Abwärme, speziell auch bei transienten Abwärmespitzen deutlich erhöht.

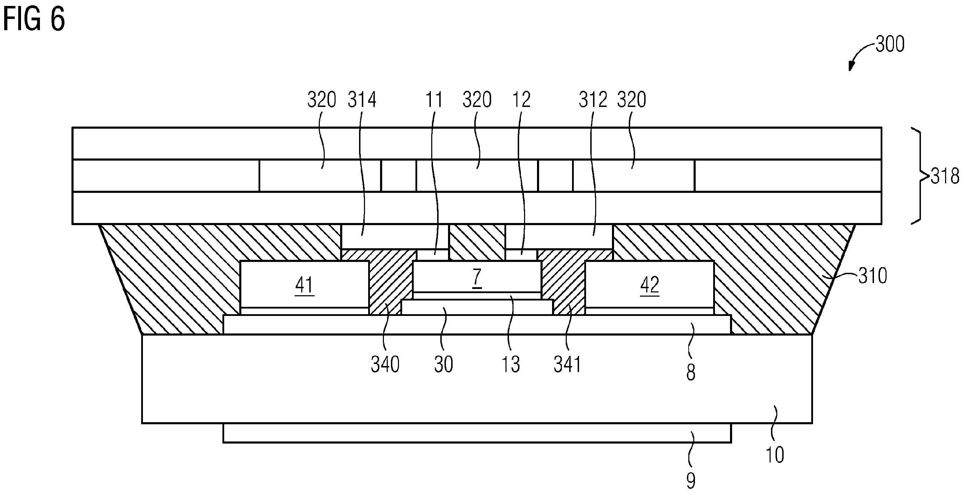

Figur 6 zeigt als weitere Ausführungsform für die Erfindung ein Leistungsmodul 300. Das Leistungsmodul 300 ist weitgehend aufgebaut wie das Leistungsmodul 100. Im Unterschied dazu sind aber die Wärmespreiz-Elemente 40 ersetzt durch Wärmespreiz-Elemente 340, 341. Diese sind dicker als das Halbleiterbauelement 7 und die Wärmekapazitäts-Elemente 41, 42. Die Wärmespreiz-Elemente 340, 341 überdecken einen Teil der Oberseite des Halbleiterbauelements 7 und auch der Wärmekapazitäts-Elemente 41, 42. Sie bilden mit den Kontaktpads 11, 12 auf der Oberseite des Halbleiterbauelements 7 eine gemeinsame bündige Fläche aus.

Das Leistungsmodul 300 umfasst weiterhin einen mehrlagigen Schaltungsträger 318 mit innenliegenden Leiterbahnen 320 und in Figur 6 nicht gezeigten Durchkontaktierungen. Der mehrlagige Schaltungsträger 318 ist oberhalb der Oberseite des Halbleiterbauelements 7 angeordnet, sodass das Halbleiterbauelement 7 zwischen dem mehrlagigen Schaltungsträger 318 und dem Leistungssubstrat angeordnet ist.

Auf dem Steuerkontakt-Kontaktpad 11 sowie auf dem bündig dazu abschließenden Wärmespreiz-Element 340 ist eine Kontaktfläche 314 aus Kupfer ausgebildet, die mit einer der Leiterbahnen 320 verbunden ist. Auf dem ersten Lastkontakt-Kontaktpad 12 und auf dem bündig dazu abschließenden Wärmespreiz-Element 341 ist eine weitere Kontaktfläche 312 aus Kupfer ausgebildet, die mit einer anderen der Leiterbahnen 320 verbunden ist.

Ein verbleibender Raumbereich zwischen der Unterseite des mehrlagigen Schaltungsträgers 318 und dem Leistungssubstrat ist durch ein Vergussmaterial 310, beispielsweise durch ein Gießharz, gefüllt.

Es ist zweckmäßig, wenn in diesem Ausführungsbeispiel die Wärmespreiz-Elemente 340, 341 keine nennenswerte elektrische Leitfähigkeit aufweisen, sie also mit anderen Worten elektrische Isolatoren sind. Die flächige Anbindung an die Kontaktflächen 312, 314 sorgt für eine weiter verbesserte Wärmespreizung und Verteilung von Abwärmespitzen. In einigen der Ausführungsformen ist also eine eineinhalb-seitige Kühlung realisiert.

### Bezugszeichen

- 7: Halbleiterbauelement
- 8, 9: Metallisierung
- 10: keramische Schicht
- 11: Steuerkontakt-Kontaktpad
- 12, 13: Lastkontakt-Kontaktpad
- 30: Verbindungsmaterial
- 40, 240, 340, 341: Wärmespreiz-Element
- 41, 42: Diamantfolie
- 100, 200, 300: Leistungsmodul
- 310: Vergussmaterial
- 312, 314: Kontaktflächen
- 318: mehrlagiger Schaltungsträger
- 320: Leiterbahn

## Patentansprüche

1. Schaltungsanordnung (100, 200, 300) mit
- einem Schaltungsträger, der auf einer Seite eine elektrisch leitfähige Schicht (8) aufweist,
- einem auf der elektrisch leitfähigen Schicht (8) angeordneten Halbleiterbauelement (7),
- einem Wärmeleitelement (40, 240, 340, 341) mit einer spezifischen Wärmeleitfähigkeit von wenigstens 20 W/mK, das das Halbleiterbauelement (7) lateral zu wenigstens 50% umschließt und in mechanischem Kontakt mit den Seitenflächen des Halbleiterbauelements (7) steht und wenigstens die halbe Höhe des Halbleiterbauelements (7) aufweist.

2. Schaltungsanordnung (100, 200, 300) nach Anspruch 1, bei der das Wärmeleitelement (40, 240, 340, 341) eine spezifische Wärmeleitfähigkeit von wenigstens 40 W/mK, insbesondere wenigstens 200 W/mK, insbesondere wenigstens 350 W/mK aufweist.

3. Schaltungsanordnung (100, 200, 300) nach Anspruch 1, bei der das Wärmeleitelement (40, 240, 340, 341) das Halbleiterbauelement (7) zu wenigstens 80%, insbesondere vollständig lateral umschließt.

4. Schaltungsanordnung (100, 200, 300) nach Anspruch 1, bei der das Wärmeleitelement (40, 240, 340, 341) wenigstens 90% der Höhe des Halbleiterbauelements (7) aufweist, insbesondere seine volle Höhe aufweist und die gesamten Seitenflächen des Halbleiterbauelements (7) bedeckt.

5. Schaltungsanordnung (100, 200, 300) nach Anspruch 1, bei der das Wärmeleitelement (40, 240, 340, 341) höher als das Halbleiterbauelement (7) ist und einen Teil der vom Schaltungsträger abgewandten Oberseite des Halbleiterbauelements (7) bedeckt.

6. Schaltungsanordnung (100, 200, 300) nach Anspruch 1, bei der das Wärmeleitelement (40, 240, 340, 341) elektrisch isolierend ist.

7. Schaltungsanordnung (100, 200, 300) nach Anspruch 1, bei der das Wärmeleitelement (40, 240, 340, 341) elektrisch leitfähig ist.

8. Schaltungsanordnung (100, 200, 300) nach Anspruch 1 mit einem mechanisch mit dem Wärmeleitelement (40, 240, 340, 341) verbundenen Wärmespeicherelement (41, 42), wobei das Wärmespeicherelement (41, 42) neben dem Halbleiterbauelement (7) auf dem Schaltungsträger angeordnet ist und eine Wärmekapazität von wenigstens 0,01 J/K aufweist.

9. Schaltungsanordnung (100, 200, 300) nach Anspruch 1, bei dem das Wärmespeicherelement (41, 42) eine Diamantfolie umfasst.

10. Schaltungsanordnung (100, 200, 300) nach Anspruch 1 mit einem auf einer Oberseite des Halbleiterbauelements (7) angeordneten zweiten Schaltungsträger (318).

11. Schaltungsanordnung (100, 200, 300) nach Anspruch 10, bei der das Halbleiterbauelement (7) auf seiner Oberseite wenigstens eine Kontaktfläche (11, 12) aufweist und der zweite Schaltungsträger (318) auf seiner dem Halbleiterbauelement (7) zugewandten Seite wenigstens eine Kontaktfläche (312, 314) zur Kontaktierung der Kontaktfläche (11, 12) aufweist.

12. Schaltungsanordnung (100, 200, 300) nach Anspruch 11 und Anspruch 5, bei der das Wärmeleitelement (40, 240, 340, 341) wenigstens einen Teil einer über die Kontaktfläche hinausragenden Fläche der Kontaktfläche (312, 314) bedeckt.
